# EUROPEAN PATENT SPECIFICATION

(11) **EP 3 244 713 B1**
(45) Date of publication and mention of the grant of the patent: **24.02.2021**
(21) Application number: 15876817.6
(22) Date of filing: 05.01.2015
(51) Int. Cl.: H05K 3/34, H01L 21/60, H05K 13/02, H05K 13/04, H05K 13/08

(54) **SOLDER BALL INFORMATION MANAGEMENT SYSTEM FOR SOLDER BALL FEEDER**
SYSTEM ZUR VERWALTUNG VON LÖTKUGELINFORMATION FÜR LÖTKUGELZUFÜHRVORRICHTUNG
SYSTÈME DE GESTION D'INFORMATIONS DE BILLE DE SOUDURE POUR SYSTÈME D'ALIMENTATION EN BILLES DE SOUDURE

(43) Date of publication of application: 15.11.2017
(73) Proprietor: FUJI Corporation, Chiryu Aichi (JP)
(72) Inventor: MURASE, Hiroki, Chiryu Aichi (JP)
(74) Representative: Grünecker Patent- und Rechtsanwälte PartG mbB
(86) International application number: PCT/JP2015/050065
(87) International publication number: WO 2016/110939

(56) References cited:
- JP-A- H10 261 675
- JP-A- 2000 315 896
- JP-A- 2011 091 192
- JP-A- 2011 091 207
- JP-A- 2013 229 428

## Description

### Technical Field

The present invention relates to a solder ball feeder solder ball information management system that manages information such as diameter, arrangement pitch, and arrangement quantity of solder balls supplied by a solder ball feeder.

### Background Art

As disclosed in patent literature 1 (JP-A-2011-91192), there is a solder ball feeder that supplies solder balls to a component mounter, the solder ball feeder being provided with a squeegee in which are formed spaces for housing solder balls, and a ball arranging plate formed with a specified arrangement pattern of a specified quantity of holes each one of which houses a solder ball, and the feeder performing squeegee operation to insert the solder balls that are in the squeegee into each one of the ball holes of the ball arrangement plate from a lower end opening of the squeegee by sliding the ball arrangement plate or the squeegee in a state with the lower end of the squeegee and the upper surface of the ball arrangement plate in tight contact or in close proximity. Other examples are known from JP 2011 091192 A and JP 2000 315896 A.

With the solder ball feeder, because the diameter of solder balls that can arranged in the ball arrangement plate is decided by the diameter of the ball holes of the ball arrangement plate, during changeover, when changing the diameter of the solder balls being used, the ball arrangement plate is changed to one formed with ball holes of a diameter that matches the diameter of the solder balls. Also, there are cases in which a suction nozzle needs to be changed based on the diameter of solder balls that are to be used, or the movement amount in the horizontal direction (XY direction) of a suction nozzle needs to be changed based on the arrangement pitch of the solder balls, and cases in which the arrangement quantity of the solder balls changes based on the ball arrangement plate being used. Therefore, whenever changeover is performed to change the ball arrangement plate being used, it is necessary for an operator to re-specify settings by entering information such as the diameter, arrangement pitch, and arrangement quantity of the solder balls.

### Citation List

Patent Literature 1: JP-A-2011-91192

### Summary of Invention

### Technical Problem

However, not only is work by an operator to re-specify settings by entering information such as the diameter, arrangement pitch, and arrangement quantity of the solder balls whenever changeover of a ball arrangement plate is performed extremely time-consuming, setting mistakes are possible by an operator entering solder ball information incorrectly.

Therefore, an object of the present invention is to provide a solder ball feeder solder ball information management system that manages information such as diameter, arrangement pitch, and arrangement quantity of solder balls supplied by a solder ball feeder.

### Solution to Problem

To solve the above problem, the present invention is a solder ball information management system for a solder ball feeder equipped with a squeegee in which a space is formed for housing many solder balls, a ball arranging plate formed with a specified arrangement pattern of a specified quantity of holes each one of which houses a solder ball, and a drive means that performs squeegee operation of inserting the solder balls that are in the squeegee into each one of the ball holes of the ball arrangement plate from a lower end opening of the squeegee by sliding the ball arrangement plate or the squeegee in a state with a lower end of the squeegee and an upper surface of the ball arrangement plate in tight contact or in close proximity, the solder
ball information management system characterised in that the ball arrangement plate includes a solder ball information storing section configured to store information (hereinafter referred to as "solder ball information") related to solder balls arranged in the ball arrangement plate at
specified positions of the ball arrangement plate; and in that the ball information management system further comprises a solder ball information reading means configured to read the solder ball information from the solder ball information storing section.

With this configuration, it is possible to specify settings automatically by reading solder ball information from the solder ball information recording section of the ball arrangement plate using the solder ball information reading means after changeover of the ball arrangement plate, therefore an operator does not have to perform troublesome work of entering solder ball information when performing changeover of a ball arrangement plate, simplifying work of an operator when performing changeover of a ball arrangement plate and preventing human errors of an operator entering incorrect solder ball information.

Here, the solder ball information may include information of a diameter, an arrangement pitch, and an arrangement quantity of solder balls arranged in the ball arrangement plate, and may also include a position of a solder ball to be picked up first (pickup start position).

With the present invention, the solder ball feeder may be set on a component mounter, the solder ball information reading means may be provided on the component mounter, and a control device of the component mounter may cause a suction nozzle of the component mounter to pick up the solder balls arranged on the ball arrangement plate in order based on the solder ball information read by the solder ball information reading means.

In this case, the solder ball information recording section provided on the ball arrangement plate may be an item with a code such as a barcode or 2D code, or may be an electronic tag that records electronically, or magnetic tape that records magnetically, and so on. The solder ball information reading means that reads the solder ball information from the solder ball information recording section may be a dedicated reader according to the recording method of the solder ball information recording section, but being a dedicated reader will increase costs.

Therefore, considering the fact that a mark-imaging-use camera that images reference marks and so on of a circuit board is provided as standard on the component mounter on which the solder ball feeder is set, a code representing the solder ball information may be recorded on a solder ball information recording section, and the solder ball information reading means may read the solder ball information by using a mark-imaging-use camera provided on the component mounter to image the solder ball information recording section and perform image recognition of the code. Accordingly, it is possible to use the mark-imaging-use camera that images reference marks and so on of a circuit board as the solder ball information reading means as well, thereby satisfying a demand for lower costs.

### Brief Description of Drawings

[Fig. 1]Fig. 1 is a perspective view of a solder ball feeder of an embodiment of the present invention.
[Fig. 2] Fig. 2 is a perspective view of the main sections of the solder ball feeder.
[Fig. 3] Fig. 3 is a plan view of a ball arrangement plate.
[Fig. 4] Fig. 4 is a perspective view of a feeder setting table of a component mounter.
[Fig. 5]Fig. 5 is a block diagram showing the configuration of control items of the component mounter.

### Description of Embodiments

An embodiment of the invention is described below.

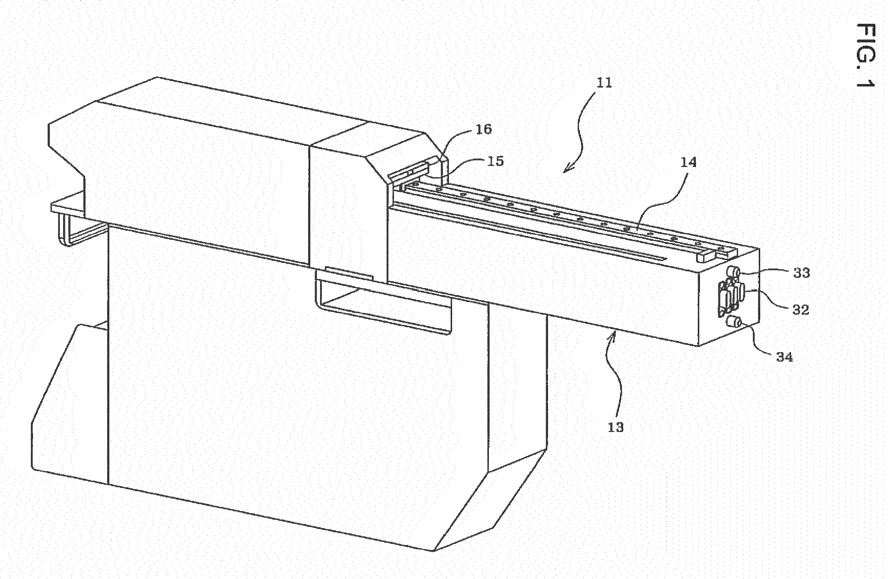

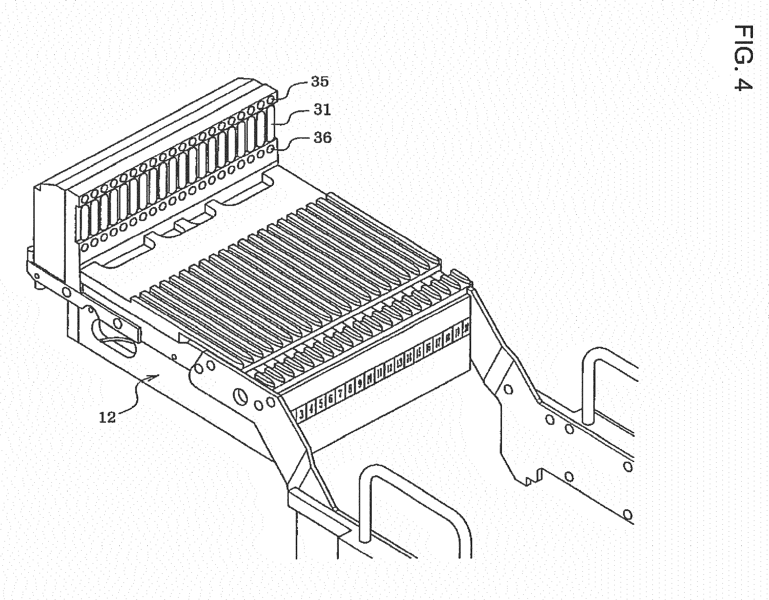

First, the configuration of solder ball feeder 11 is described with reference to figs. 1 to 4. Solder ball feeder 11 is set on feeder setting table 12 (refer to fig. 4) of a component mounter (not shown) to be replaceable with a tape feeder (not shown) . The width dimension of solder ball feeder 11 is approximately two to three times that of a tape feeder, and solder ball feeder 11 is removably set on feeder setting table 12 occupying the space of two to three tape feeders.

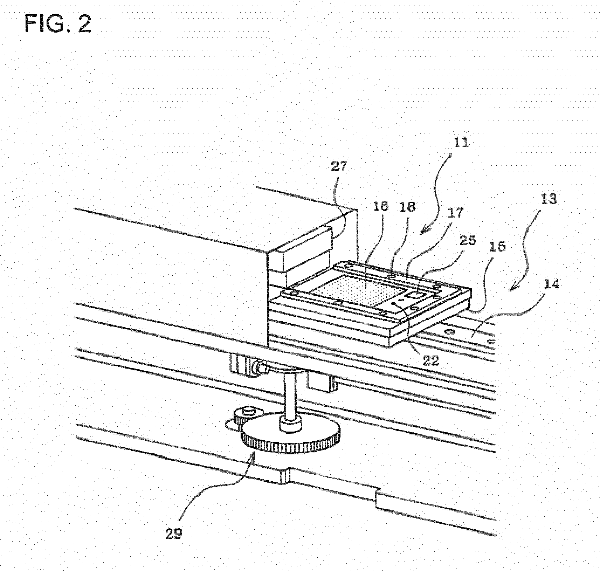

As shown in fig. 1, feeder main body 13 is provided on an upper section of solder ball feeder 11, feeder main body 13 being box-shaped and long in the front-rear direction that is the direction in which the feeder is attached to and removed from feeder setting table 12 of the component mounter (refer to fig. 4), and guide rail 14 being provided on feeder main body 13 extending in the front-rear direction. As shown in fig. 2, slide base 15 is supported on guide rail so as to be slidable in the front-rear direction, and ball arrangement plate 16 is inserted into C-shaped fixing frame 17 on slide base 15, ball arrangement plate 16 being attached in a removable manner by bolts 18.

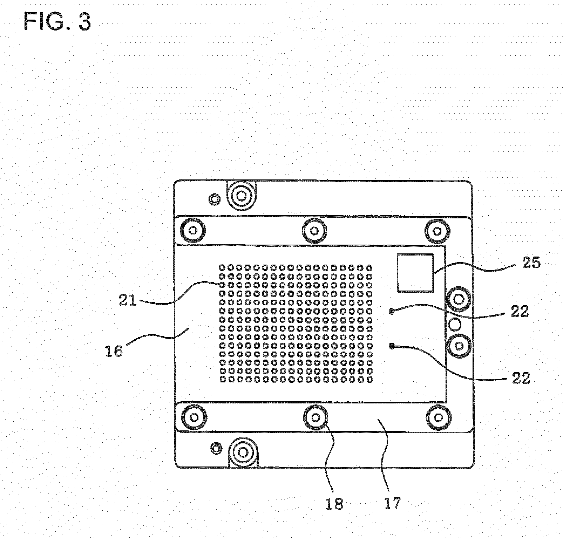

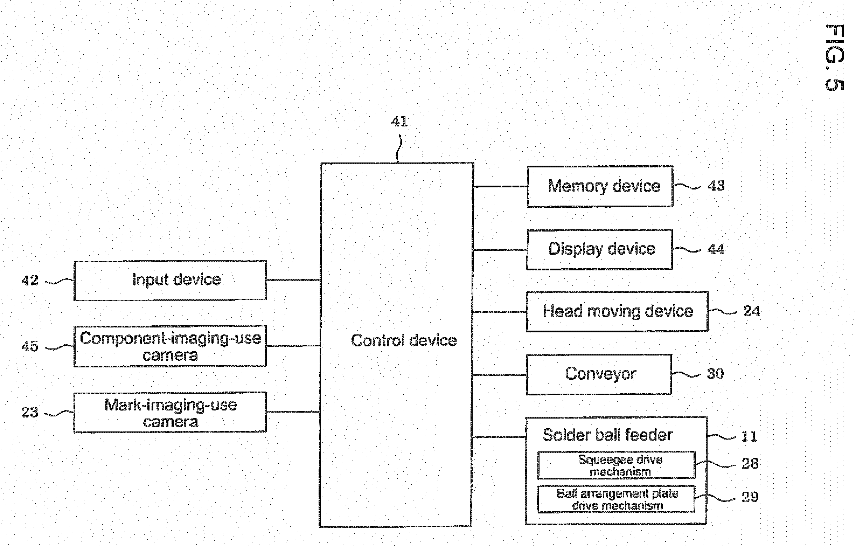

As shown in fig. 3, a specified quantity of ball holes 21, each of which accommodates a single solder ball, is formed in a specified arrangement pattern on ball arrangement plate 16. For example, two position correction marks 22 are formed at a specified position on a front side (the attachment direction side of solder ball feeder 11) surrounding portion on ball arrangement plate 16 at which ball holes 21 are not formed, and by recognizing position correction marks 22 by imaging position correction marks 22 using mark-imaging-use camera 23 (refer to fig. 5) provided on the component mounter, the position of each ball hole 21 of ball arrangement plate 16 is corrected based on the position of position correction marks 22. Mark-imaging-use camera 23 is provided to be moved as one with the mounting head (not shown) by head moving device 24 of the component mounter, and component mounting positions on the circuit board are corrected based on the position of reference marks of the circuit board on conveyor 30 by recognizing the reference marks by imaging the reference marks using mark-imaging-use camera 23.

Solder ball information recording section 25 is provided at a specified position on a front side (the attachment direction side of solder ball feeder 11) surrounding portion on ball arrangement plate 16 at which ball holes 21 are not formed. Information such as solder ball diameter, arrangement pitch, arrangement quantity, and position of first solder ball to be picked up (pickup start position) that is information related to solder balls arranged on ball arrangement plate 16 is recorded on an upper surface of solder ball information recording section 25 in the form of a code such as a barcode or 2D code.

In the present embodiment, mark-imaging-use camera 23 provided on the component mounter is used as a solder ball information reading means that reads solder ball information from solder ball information recording section 25, with solder ball information being set to be read automatically by imaging solder ball information recording section 25 with mark-imaging-use camera 23 and performing image recognition of the code.

As shown in fig. 2, squeegee 27 formed with a space that stores many solder balls is provided on a rear side (removal direction side of solder ball feeder 11) of feeder main body 13 so as to be slidable in the front-rear direction, and the height position of squeegee 27 is adjusted such that the lower end of squeegee 27 tightly contacts or comes into close proximity to the upper surface of ball arrangement plate 16 when squeegee 27 is slid over the upper surface of ball arrangement plate 16.

Squeegee drive mechanism 28 (refer to fig. 5) that slides squeegee 27 in the front-rear direction is provided inside feeder main body 13, and an interlock functions such that squeegee 27 can only be slid by squeegee drive mechanism 28 when ball arrangement plate 16 is at the origin position shown in fig. 2, regardless of whether solder ball feeder 11 is in automatic operation or manual operation mode. With ball arrangement plate 16 stopped at the origin position shown in fig. 2, by performing squeegee operation of making the lower end of squeegee 27 to be in tight contact with or close proximity to the upper surface of ball arrangement plate 16, and sliding squeegee 27 forwards over the upper surface of ball arrangement plate 16 using squeegee drive mechanism 28, solder balls inside squeegee 27 are inserted into each ball hole 21 of ball arrangement plate 16 from lower end openings of squeegee 27 such that a specified quantity of solder balls are arranged on ball arrangement plate 16 in a specified arrangement pattern. Note that, solder balls inside squeegee 27 may be inserted into each ball hole 21 of ball arrangement plate 16 from lower end openings of squeegee 27 by sliding ball arrangement plate 16 with the lower end of squeegee 27 in a state in tight contact with or close proximity to the upper surface of ball arrangement plate 16.

Ball arrangement plate drive mechanism 29 (drive means) that slides ball arrangement plate 16 (slide base 15) in the front-rear direction is provided inside feeder main body 13, and ball arrangement plate 16 is slid to and from the origin position shown in fig. 2 and the solder ball pickup position at the front end of feeder main body 13 by ball arrangement plate drive mechanism 29. After solder balls have been housed in each ball hole 21 of ball arrangement plate 16 by sliding squeegee 27 in the forwards direction over the top surface of ball arrangement plate 16 at the origin position shown in fig. 2, ball arrangement plate 16 is slid to the solder ball pickup position at the front end of feeder main body 13, and the solder balls in each ball hole 21 of ball arrangement plate 16 are picked up in order by a suction nozzle of the component mounter and mounted on the circuit board on conveyor 30.

As shown in fig. 1, connector 32 and two positioning pins 33 and 34 for connecting the signal wire and power wire of solder ball feeder 11 to connector 31 (refer to fig. 4) of feeder setting table 12 of the component mounter are provided at the front end (end surface in the attaching direction) of feeder main body 13; by inserting the two positioning pins 33 and 34 into positioning holes 35 and 36 (refer to fig. 4) of feeder setting table 12 of the component mounter, the attachment position of solder ball feeder 11 on feeder setting table 12 is decided, and connector 32 of solder ball feeder 11 is connected to connector 31 of feeder setting table 12.

As shown in fig. 5, connected to control device 41 of the component mounter are, for example, input device 42 such as a keyboard, mouse, or touchscreen panel; memory device 43 (memory means) including a hard disk, RAM, ROM and so on for memorizing various types of programs, data, and the like; and display device 44 such as a liquid crystal display or CRT. In addition, component-imaging-use camera 45 that images components such as solder balls held by suction nozzles (not shown) from below, and so on, is provided on the component mounter.

When an operator replaces ball arrangement plate 16 of solder ball feeder 11 with another ball arrangement plate 16 with a different diameter of ball hole 21 (hereinafter referred to as "during changeover of ball arrangement plate 16"), after ball arrangement plate 16 of solder ball feeder 11 is slid to the solder ball pickup position, control device 41 of the component mounter automatically reads the solder ball information by imaging solder ball information recording section 25 of ball arrangement plate 16 using mark-imaging-use camera 23 of the component mounter and performing image recognition of the code, and then the solder balls arranged on ball arrangement plate 16 are picked up in order by a suction nozzle (not shown) of the component mounter based on the solder ball information.

According to the embodiment described above, because it is possible to specify settings automatically by reading solder ball information from solder ball information recording section 25 of ball arrangement plate 16 using mark-imaging-use camera 23 of the component mounter after changeover of ball arrangement plate 16, an operator does not have to perform troublesome work of entering solder ball information during changeover of ball arrangement plate 16, simplifying work of an operator during changeover of ball arrangement plate 16 and preventing human errors of an operator entering incorrect solder ball information.

Further, because with the present embodiment, considering the fact that mark-imaging-use camera 23 that images reference marks and so on of a circuit board is provided as standard on the component mounter on which solder ball feeder 11 is set, a code representing the solder ball information is recorded on the upper surface solder ball information recording section 25, mark-imaging-use camera 23 provided on the component mounter is used as a solder ball information reading means, and the solder ball information is read by imaging solder ball information recording section 25 with mark-imaging-use camera 23 and performing image recognition of the code, meaning that it is possible to use mark-imaging-use camera 23 that images reference marks and so on of a circuit board as the solder ball information reading means as well, thereby satisfying a demand for lower costs.

Note that, solder ball information recording section 25 provided on ball arrangement plate 11 is not limited to an item recorded with a code such as a barcode or 2D code, it may be an electronic tag that records electronically, or magnetic tape that records magnetically, and so on. In such a case, the solder ball information reading means that reads the solder ball information from solder ball information recording section 25 may be a dedicated reader according to the recording method of solder ball information recording section 25.

In addition, the present invention is not limited to the embodiments described above but is defined and limited by the appended claims

### Reference Signs List

11: solder ball feeder; 12: feeder setting table; 13: feeder main body; 14: guide rail; 15: slide base; 16: ball arrangement plate; 21: ball hole; 22: position correction mark; 23: mark-imaging-use camera; 24: head moving device; 25: solder ball information recording section; 27: squeegee; 28: squeegee drive mechanism; 29: ball arrangement drive mechanism (drive means); 41: control device of component mounter

## Claims

1. A solder ball information management system comprising a solder ball feeder (11) equipped with a squeegee (27) in which a space is formed for housing many solder balls, a ball arrangement plate (16) formed with a specified arrangement pattern of a specified quantity of holes (21) each one of which is configured to house a solder ball, and a drive means (28, 29) that is configured to perform squeegee operation of inserting the solder balls that are in the squeegee (27) into each one of the ball holes (21) of the ball arrangement plate (16) from a lower end opening of the squeegee (27) by sliding the ball arrangement plate (16) or the squeegee (27) in a state with a lower end of the squeegee (27) and an upper surface of the ball arrangement plate (16) in tight contact or in close proximity,
the solder ball information management system being **characterized in that**
the ball arrangement plate (16) includes a solder ball information storing section (25) configured to store solder ball information which is information related to solder balls arranged in the ball arrangement plate (16) at specified positions of the ball arrangement plate (16);
and **in that** the solder ball information management system further comprises
a solder ball information reading means (23) configured to read the solder ball information from the solder ball information storing section (25).

2. The solder ball information management system according to claim 1, wherein
the solder ball information includes information of a diameter, an arrangement pitch, and an arrangement quantity of solder balls arranged in the ball arrangement plate (16).

3. The solder ball information management system according to claim 1 or claim 2, wherein
the solder ball feeder (11) is set on a component mounter, the solder ball information reading means (23) is provided on the component mounter, and a control device (41) of the component mounter is configured to cause a suction nozzle of the component mounter to pick up the solder balls arranged on the ball arrangement plate (16) in order based on the solder ball information read by the solder ball information reading means (23).

4. The solder ball information management system according to claim 3, wherein
a code representing the solder ball information is recorded on the solder ball information recording section (25), and the solder ball information reading means (23) is configured to read the solder ball information by using a mark-imaging-use camera (23) provided on the component mounter to image the solder ball information recording section (25) and performing image recognition of the code.

## Patentansprüche

1. System für Verwaltung von Lotkugel-Informationen, umfassend eine Lotkugel-Zuführeinrichtung (11), die mit einer Aufbringeinrichtung (27) ausgestattet ist, in der ein Raum zum Aufnehmen vieler Lotkugeln ausgebildet ist, eine Kugelanordnungs-Platte (16), die mit einem vorgegebenen Anordnungsmuster einer vorgegebenen Anzahl von Löchern (21) versehen ist, von denen jedes so ausgeführt ist, dass es eine Lotkugel aufnimmt, sowie eine Antriebseinrichtung (28, 29), die so ausgeführt ist, dass sie einen Aufbringvorgang durchführt, in dem die Lotkugeln, die sich in der Aufbringeinrichtung (27) befinden, in jedes der Kugellöcher (21) der Kugelanordnungs-Platte (16) von einer unteren Endöffnung der Aufbringeinrichtung (27) her eingeführt werden, indem die Kugelanordnungs-Platte (16) oder die Aufbringeinrichtung (27) in einem Zustand verschoben wird, in dem ein unteres Ende der Aufbringeinrichtung (27) und eine obere Fläche der Kugelanordnungs-Platte (16) in engen Kontakt miteinander oder nahe beieinander sind,
wobei das System für Verwaltung von Lotkugel-Informationen **dadurch gekennzeichnet ist, dass**
die Kugelanordnungs-Platte (16) einen Abschnitt (25) zum Speichern von Lotkugel-Informationen enthält, der zum Speichern von Lotkugel-Informationen ausgeführt ist, die Informationen sind, die sich auf Lotkugeln beziehen, die in der Kugelanordnungs-Platte (16) an vorgegebenen Positionen der Kugelanordnungs-Platte (16) angeordnet sind;
und dass das System für Verwaltung von Lotkugel-Informationen des Weiteren
eine Einrichtung (23) zum Lesen von Lotkugel-Informationen umfasst, die zum Lesen der Lotkugel-Informationen aus dem Abschnitt (25) zum Speichern von Lotkugel-Informationen ausgeführt ist.

2. System für Verwaltung von Lotkugel-Informationen nach Anspruch 1, wobei
die Lotkugel-Informationen Informationen über einen Durchmesser, einen Anordnungsabstand sowie eine Anordnungsmenge in der Kugelanordnungs-Platte (16) angeordneter Lotkugeln einschließen.

3. System für Verwaltung von Lotkugel-Informationen nach Anspruch 1 oder Anspruch 2, wobei
die Lotkugel-Zuführeinrichtung (11) in eine Bauteil-Montagevorrichtung eingesetzt ist, die Einrichtung (23) zum Lesen von Lotkugel-Informationen an der Bauteil-Montagevorrichtung vorhanden ist, und eine Steuerungsvorrichtung (41) der Bauteil-Montagevorrichtung so ausgeführt ist, dass sie eine Saugdüse der Bauteil-Montagevorrichtung veranlasst, die auf der Kugelanordnungs-Platte (16) angeordneten Lotkugeln auf Basis der von der Einrichtung (23) zum Lesen von Lotkugel-Informationen gelesenen Lotkugel-Informationen der Reihe nach aufzunehmen.

4. System für Verwaltung von Lotkugel-Informationen nach Anspruch 3, wobei
ein Code, der die Lotkugel-Informationen repräsentiert, auf dem Abschnitt (25) zum Aufzeichnen von Lotkugel-Informationen aufgezeichnet ist, und die Einrichtung (23) zum Lesen von Lotkugel-Informationen so ausgeführt ist, dass sie die Lotkugel-Informationen liest, indem sie eine Kamera (23) zum Einsatz zur Markierungs-Bilderzeugung nutzt, die an der Bauteil-Montagevorrichtung vorhanden ist, um ein Bild des Abschnitts (25) zum Aufzeichnen von Lotkugel-Informationen zu erzeugen, und Bilderkennung des Codes durchführt.

## Revendications

1. Système de gestion d'informations sur des billes de brasage comprenant un chargeur de billes de brasage (11) équipé d'une racle (27) dans laquelle un espace est constitué pour accueillir de nombreuses billes de brasage, une plaque de disposition de billes (16) constituée avec un schéma de disposition spécifique d'une quantité spécifiée de trous (21) chacun desquels est configuré pour accueillir une bille de brasage, et un moyen d'entraînement (28, 29) qui est configuré pour exécuter un fonctionnement de racle d'insertion des billes de brasage qui sont dans la racle (27) dans chacun des trous à billes (21) de la plaque de disposition de billes (16) depuis une ouverture d'extrémité inférieure de la racle (27) en faisant glisser la plaque de disposition de billes (16) ou la racle (27) dans un état où une extrémité inférieure de la racle (27) et une surface supérieure de la plaque de disposition de billes (16) sont en contact étroit ou à étroite proximité,
le système de gestion d'informations sur des billes de brasage étant **caractérisé en ce que**
la plaque de disposition de billes (16) inclut une section de stockage d'informations sur des billes de brasage (25) configurée pour stocker des informations sur des billes de brasage qui sont des informations relatives à des billes de brasage disposées dans la plaque de disposition de billes (16) à des emplacements spécifiés de la plaque de disposition de billes (16) ;
et **en ce que** le système de gestion d'informations sur des billes de brasage comprend
un moyen de lecture d'informations sur des billes de brasage (23) configuré pour lire les informations sur des billes de brasage à partir de la section de stockage d'informations sur des billes de brasage (25).

2. Le système de gestion d'informations sur des billes de brasage selon la revendication 1, dans lequel
les informations sur des billes de brasage incluent des informations sur un diamètre, un pas de disposition et une quantité de disposition de billes de brasage disposées dans la plaque de disposition de billes (16).

3. Le système de gestion d'informations sur des billes de brasage selon la revendication 1 ou la revendication 2, dans lequel
le chargeur de billes de brasage (11) est installé sur un monteur de composants, le moyen de lecture d'informations sur des billes de brasage (23) est disposé sur le monteur de composants, et un dispositif de contrôle (41) du monteur de composants est configuré pour faire prélever par une buse d'aspiration du monteur de composants les billes de brasage disposées sur la plaque de disposition de billes (16) dans un ordre reposant sur les informations sur des billes de brasage lues par le moyen de lecture d'informations sur des billes de brasage (23).

4. Le système de gestion d'informations sur des billes de brasage selon la revendication 3, dans lequel
un code représentant les informations sur des billes de brasage est enregistré sur la section d'enregistrement d'informations sur des billes de brasage (25), et le moyen de lecture d'informations sur des billes de brasage (23) est configuré pour lire les informations sur des billes de brasage en utilisant une caméra marquage-imagerie-utilisation (23) disposée sur le monteur de composants pour prendre une image de la section d'enregistrement d'informations sur des billes de brasage (25) et procéder à une reconnaissance d'image du code.
